# EUROPEAN PATENT SPECIFICATION

(11) **EP 3 776 781 B1**
(45) Date of publication and mention of the grant of the patent: **23.04.2025**
(21) Application number: 18721365.7
(22) Date of filing: 27.04.2018
(51) Int. Cl.: H02H 5/12, H02H 11/00, G05F 1/625

(54) **POWER SOURCE, LOAD AND METHODS FOR PROVIDING AND RECEIVING POWER**
STROMQUELLE, LAST UND VERFAHREN FÜR BEREITSTELLUNG UND EMPFANG VON LEISTUNG
SOURCE D'ALIMENTATION, CHARGE ET PROCÉDÉS DESTINÉS À FOURNIR ET RECEVOIR DE L'ÉNERGIE

(43) Date of publication of application: 17.02.2021
(73) Proprietor: HUAWEI TECHNOLOGIES CO., LTD., Shenzhen, Guangdong 518129 (CN)
(72) Inventor: TABAKOV, Michael, 80992 Munich (DE); STIEDL, Andreas, 80992 Munich (DE); KOLOS, Mario, 80992 Munich (DE)
(74) Representative: Isarpatent
(86) International application number: PCT/EP2018/060969
(87) International publication number: WO 2019/206433

(56) References cited:
- EP-A1- 0 384 881
- EP-A2- 2 270 945
- WO-A1-2016/174644
- US-A1- 2015 373 811

## Description

### TECHNICAL FIELD

The present invention generally relates to the field of communication network technology. Particularly, the present invention relates to power distribution from a power source to a load.

### BACKGROUND

In the sector of the telecom power distribution as well in general power systems the power demand increases. One way to distribute more energy is to increase the voltage. Formally 48 V was a very popular secure extra low voltage used in a variety of areas such as communication networks.

When using higher voltages up to 400 VDC, certain safety regulations are defined in ETSI EN 302 099 V2.1.13 ensuring that a power source is only turned on and a load is only supplied with voltage if there is a load connected and the load is of an appropriate type. It is strictly to be avoided to power open cables and other connection means with hazardous voltages, i.e. voltages above 60 VDC.

WO 2016/174644 A1 discloses a power supply control device which comprises a controller and power connection circuitry.

EP 2 270945 A2 discloses a system and a method for controlling connection of an electrical outlet to a power source so as to exclude the human body model.

### SUMMARY

One of the problems of conventional solutions is that the load is without power and therefore there is no way of communication to check the power connection and the load itself.

Having recognized the above-mentioned disadvantages and problems, the present invention aims at improving the state of the art. In particular, an object of the present invention is to provide a power source, a load and methods for providing and receiving power.

This objective is achieved by the features of the independent claims. Further embodiments of the invention are apparent from the dependent claims, the description and the figures.

According to a first aspect, the invention relates to a power source. The power source comprises an output for a load. The power source is configured to provide a first voltage at the output. The power source is configured to detect a feedback at the output. The power source is further configured to provide a second voltage at the output based on the detected feedback.

Thereby, a high second voltage is only provided if an appropriate load is detected. This has the advantage that people are protected from electric shock e.g. when handling unconnected cables.

According to an implementation of the first aspect, the detected feedback is a measured current when the first voltage is provided.

Thereby, the feedback is characterized further. This has the advantage that the power distribution and the load type can be verified by using the low voltage without using an additional interface.

According to an implementation of the first aspect, the power source is configured to detect the feedback by determining a pattern of the measured current.

Thereby, the load type is determined based on a specific current pattern. This has the advantage that different load types are supported.

According to an implementation of the first aspect, the pattern is defined by one or more of a frequency, a duty cycle and a digital bit pattern.

Thereby, the current pattern are defined in more detail. This has the advantage that different options of identifying the type of the load are available.

According to an implementation of the first aspect, the power source further comprises an input configured to receive an input voltage and a voltage converter module configured to generate the first voltage based on the input voltage. The power source further comprises a switch connected between the input and the output, wherein the power source is configured to operate the switch in a first position for providing the first voltage at the output, and operate the switch in a second position for providing the second voltage at the output.

Thereby, the generation of the first and second voltage is described in more detail. This has the advantage that providing the second voltage is done by simple means.

According to an implementation of the first aspect, the voltage converter module has an output and wherein the output of the voltage converter is coupled to the output of the power source via a reverse power protection module.

Thereby, the current from the output into the voltage converter module is prevented. This has the advantage that the voltage converter is protected against reverse current.

According to an implementation of the first aspect, the power source is configured to deactivate the voltage converter module when the second voltage is provided.

Thereby, the function of the voltage converter module is defined in more detail. This has the advantage that power is saved when the second voltage is provided.

According to an implementation of the first aspect, the power source further comprises an over-current protection module configured to provide the first voltage with a current limit.

Thereby, the output power is limited. This has the advantage that short cuts are not critical.

According to an implementation of the first aspect, the first voltage is less than the second voltage. In particular, the first voltage is below 60 VDC and the second voltage is a hazardous voltage.

Thereby, the voltages are specified in more detail. The second voltage being higher than the first voltage has the advantage that higher power can be distributed.

According to an implementation of the first aspect, the first voltage is a secure extra low voltage, SELV.

Thereby, the voltages are specified in more detail. This has the advantage that there is a protection form electric shock when the first voltage is provided.

According to a second aspect, the invention relates to a method for providing power. The method comprises providing a first voltage at an output to a load. The method comprises detecting a feedback at the output. The method comprises providing a second voltage at the output based on the detected feedback.

Thereby, a high second voltage is only provided if an appropriate load is detected. This has the advantage that people are protected from electric shock, e.g. when handling unconnected cables.

According to an implementation of the second aspect, the method comprises detecting the feedback by measuring a current when the first voltage is provided.

Thereby, the feedback is characterized further. This has the advantage that the power distribution and the load type can be verified by using the low voltage without using an additional interface.

According to an implementation of the second aspect, the method comprises detecting the feedback by determining a pattern of the measured current.

Thereby, the load type is determined based on a specific current pattern. This has the advantage that different load types are supported.

According to an implementation of the second aspect, the pattern is defined by one or more of a frequency, a duty cycle and a digital bit pattern.

Thereby, the current pattern are defined in more detail. This has the advantage that different options of identifying the type of the load are available.

According to an implementation of the second aspect, the method further comprises receiving an input voltage and generating the first voltage based on the received input voltage. The method further comprises switching the first voltage or the second voltage at the output.

Thereby, the generation of the first and second voltage is described in more detail. This has the advantage that providing the second voltage is done by simple means.

According to an implementation of the second aspect, the first voltage is coupled to the output via a reverse power protection module.

Thereby, the current from the output into a voltage converter module generating the first voltage is prevented. This has the advantage that the voltage converter is protected against reverse current.

According to an implementation of the second aspect, the method comprises deactivating the generation of the first voltage when the second voltage is provided.

Thereby, the function of the voltage converter module is defined in more detail. This has the advantage that power is saved when the second voltage is provided.

According to an implementation of the second aspect, the method further comprises providing the first voltage with a current limit.

Thereby, the output power is limited. This has the advantage that short cuts are not critical.

According to an implementation of the second aspect, the first voltage is less than the second voltage. In particular, the first voltage s below 60 VDC and the second voltage is a hazardous voltage.

Thereby, the voltages are specified in more detail. The second voltage being higher than the first voltage has the advantage that higher power can be distributed.

According to an implementation of the first aspect, the first voltage is a secure extra low voltage, SELV.

Thereby, the voltages are specified in more detail. This has the advantage that there is a protection form electric shock when the first voltage is provided.

According to a third aspect, the invention relates to a load comprising an input and an electronic circuit. The electronic circuit is configured to determine a voltage at the input and to set a current consumption of the load based on the determined voltage. The current consumption of the load is set according to a current pattern that is associated with a type of the load.

Thereby, the load identifies its type dependent on the input voltage. This has the advantage that no additional communication interface is used to identify the load type.

According to an implementation of the third aspect, the electronic circuit is configured to set the current consumption of the load if the determined voltage is in a defined range.

Thereby, the load identifies its type by setting the current consumption. This has the advantage that discrete current settings are used to identify the load type.

According to an implementation of the third aspect, the current pattern is defined by one or more of a frequency, a duty cycle or a digital bit pattern.

Thereby, the current pattern are defined in more detail. This has the advantage that different options of identifying the load are available.

According to a fourth aspect, the invention relates to method for receiving power at a load. The method comprises determining an input voltage, and, based on the determining, set a current consumption of the load according to a current pattern that is associated with a type of the load.

Thereby, the load communicates its type in dependence of the input voltage. This has the advantage that no additional communication interface is used to identify the load type.

According to an implementation of the fourth aspect, the method comprises setting the current consumption of the load if the determined voltage is in a defined range.

Thereby, the load communicates its type by setting the current consumption. This has the advantage that discrete current settings are used to identify the load type.

According to an implementation of the fourth aspect, the current pattern is defined by one or more of a frequency, a duty cycle or a digital bit pattern.

Thereby, the current pattern are defined in more detail. This has the advantage that different options of identifying the load are available.

According to a fifth aspect, the invention relates to a computer program having a program code for performing the method according to the second or fourth aspect or according to any implementation of the second or fourth aspect when the computer program runs on a computing device.

Thereby, the method can be performed in an automatic and repeatable manner. Advantageously, the computer program can be respectively performed at the power source according to the second aspect or at the load according to the fourth aspect.

More specifically, it should be noted that the above apparatuses, i.e., the power source and the load, may each be implemented as or comprise a discrete hardware circuitry (e.g. with discrete hardware components, integrated chips or arrangements of chip modules), or a signal processing device or chip controlled by a software routine or program stored in a memory, written on a computer-readable medium or downloaded from a network such as the internet.

It shall further be understood that a preferred embodiment of the invention can also be any combination of the dependent claims or above embodiments with the respective independent claim.

These and other aspects of the invention will be apparent and elucidated with reference to the embodiments described hereinafter.

### BRIEF DESCRIPTION OF THE THE DRAWINGS

The above aspects and implementation forms of the present invention will be explained in the following description of specific embodiments in relation to the enclosed drawings, in which:
Fig. 1 shows a block diagram of a power source according to an embodiment of the present invention;
Fig. 2 shows a block diagram of a load according to an embodiment of the present invention;
Fig. 3 shows a circuit diagram of selected modules of a power source according to an embodiment of the present invention; and
Fig. 4 shows a circuit diagram of a selected module of a load according to an embodiment of the present invention.

### DETAILED DESCRIPTION OF EMBODIMENTS OF THE INVENTION

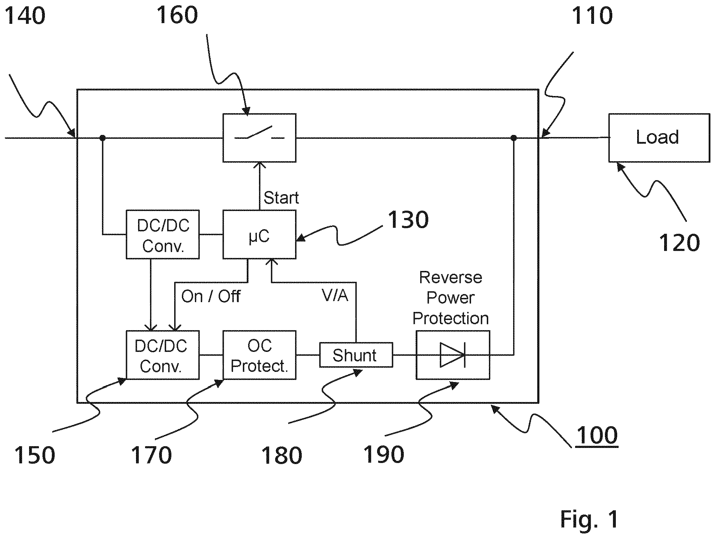

Fig. 1 shows a block diagram of a power source 100 according to an embodiment of the present invention.

The power source 100, comprises an output 110 for a load 120. The power source 100 is configured to provide a first voltage at the output 110. The power source is configured to detect a feedback at the output 100 and to provide a second voltage at the output 110 based on the the detected feedback. The feedback may be detected at the output when the first output voltage is provided at the output. The detection of the feedback may be detection of a current, for instance.

The load 120 may be connected to the power source 100 via a power distribution line. The load may be a telecommunications equipment in access networks such as an access network unit, optical network unit or remote DSL unit or any kind of access telecom equipment (i.e. network terminations, access gateway, etc.) between a telecom center or local exchange and a customer premises. In particular, the load may be an equipment in a wireless access network. The load may be located in fiber to the building, fiber to the cabinet or fiber to the curb cabinets or underground chambers or man-holes. Other types of loads are also covered by the present invention.

The first voltage may be a voltage below 60 VDC. In an embodiment, the first voltage may be a secure extra low voltage. Using voltages below 60 VDC has the advantage that there is no risk of electric shock for people working on the power transmission line cables or with the load. This may include installing the load, connecting the load to the power transmission line, disconnecting the load from the power transmission line and others. Particular examples of the first voltage are 12 VDC and 48 VDC.

The power source 100 may comprise a DC/DC converter module 150, an over-current protection module 170, a voltage/ current measurement module 180 and a reverse power protection module 190 for generating the first voltage as described in more detail below.

The DC/DC converter module 150 comprises an input and an output. DC/DC converter module 150 converts the voltage received at the input of DC/DC converter module 150 and provides a voltage corresponding to the first voltage at the output of DC/DC converter module 150. The DC/DC converter module 150 may comprise any type of switching voltage converter. In one embodiment, the input of DC/DC converter module 150 may be coupled directly to an input 140 of the power source 100. In another embodiment, there may be one or more additional voltage converter modules that convert the input voltage of the power source 100 into one or more intermediate voltages. The DC/DC converter module 150 may convert one of the intermediate voltages to the voltage corresponding to the first voltage. In one embodiment, the one or more intermediate voltages may be used to power other circuitry in the power source 100, such as microcontroller module 130.

DC/DC converter module 150 may have a control input that enables / disables DC/DC converter module 150. In one embodiment, the DC/DC converter module 150 is enabled when the voltage at the control input of DC/DC converter module 150 is below a predefined threshold. Otherwise, the DC/DC converter module 150 is disabled. In another embodiment, the DC/DC converter module 150 is enabled when the voltage at the control input of DC/DC converter module 150 is above the predefined threshold. Otherwise, the DC/DC converter module 150 is disabled. The control input of DC/DC converter module 150 may be coupled to microcontroller module 130. This allows microcontroller module or microcontroller 130 to control DC/DC converter module 150.

The over-current protection module 170 comprises an input coupled to the output of DC/DC converter module 150 and an output. If the current flowing though the output of over-current protection module 170 is larger than a predefined threshold, over-current protection module 170 limits the current. Thereby, over-current protection module 170 limits the output power of power source 100 when power source 100 provides the first voltage at the output 110 to load 120.

Current measurement module 180 comprises an input coupled to the output of over-current protection module 170 and an output. Current measurement module 180 measures the current at the output of current measurement module 180 and provides the measured current to microcontroller module 130. The current measurement module 180 may provide the measured current at a certain rate, also referred to as a sampling rate. In one embodiment, current measurement module 180 may be a voltage/current measurement module that provides both the current and the voltage at the output of current measurement module 180.

Reverse power protection module 190 comprises an input coupled to the output of voltage/ current measurement module 180 and an output that is coupled to the output 110 of the power source 100. Reverse power protection module 190 allows current flowing from the input of reverse power protection module 190 to the output of reverse power protection module 190. Reverse power protection module 190 prevents current flowing from the output of reverse power protection module 190 to the input of reverse power protection module 190. Reverse power protection module 190 may be a diode.

The power source 100 further comprises a switch module 160 coupled between the input 140 and the output 110 of the power source 100. The switch module is controlled by a microcontroller module 130.

The power source 100 comprises an input 140 for receiving an input voltage. The input voltage is higher than the first voltage. In one embodiment, the input voltage may be 220 VDC, 240 VDC or 400 VDC. In an embodiment, the input may be an alternating current (AC).

The microcontroller module 130 controls the operation of the power source 100 as described below.

In a first operating state of the power source 100, microcontroller module 130 causes the power source 100 to provide the first voltage by controlling DC/DC converter module 150 to be enabled and by controlling switching module 160 to be open. Thus, power source 100 provides a voltage lower or equal to 60V at the output 110. In the first operating state, microcontroller module 130 detects feedback at the output 110. The feedback may be a voltage or a current. In an embodiment, microcontroller module 130 detects feedback by monitoring the voltage and the current measured by voltage/ current measurement module 180. Based on the measured voltage and current, the microcontroller module 130 determines whether a load is connected to the output 110 of power source 100. If there is a load connected, the microcontroller module 130 determines the type of the connected load. If the microcontroller module 130 determines that the load is of an appropriate type of load, the microcontroller module 130 switches to a second operating state in which the second voltage is provided at the output. In the second operating state, microcontroller module 130 causes the power source 100 to provide the second voltage by controlling switch 160 to be closed. The second voltage corresponds to the voltage at the input 140 of power source 100, which is a voltage higher than 60 VDC and may be hazardous for people touching live parts of the load or the power distribution line. Thus, the second voltage is only provided if power transmission line and the type of the load has been verified by power source 100. This has the advantage that people are protected from electric shock e.g. when handling unconnected cables or when installing the load.

In one embodiment, the microcontroller module 130 may disable the DC/DC converter module 150 when it is in the second operating state and the power source provides the second voltage at the output 110. This has the advantage that power is saved when the second voltage is provided.

The microcontroller module 130 determines that the load is of an appropriate type by determining a pattern of the measured current. The pattern may be a predefined frequency, duty cycle or digital bit pattern of current changes. In one embodiment, the measured current may comprise a constant or slowly changing portion and a fast changing portion. The constant or slowly changing portion of the current may be caused by the current consumption of the circuitry of the load. The fast changing portion may be generated by the load such that the type of the load can be determined by the power source 100. The fast changing portion may comprise a temporary change of the current by a predetermined amount.

In one embodiment, the microcontroller module 130 determines the type of load by filtering out the fast changing portion from the measured current and by comparing the filtered signal against a threshold. The microcontroller module 130 may determine the type of load by determining one or more of a frequency, a duty-cycle or a bit pattern of the resulting signal. Using the current for identifying a type of load has the advantage that no additional communication interface is required for this purpose. Moreover, by using different frequencies and/or duty-cycles, a variety of different types can be identified.

In one embodiment, the microcontroller module 130 being in the first operating state may determine based on the measured voltage and current that the output 110 of power source 100 is short-circuited. In this case, microcontroller module 130 may control DC/DC converter module 150 to be disabled for a certain period of time. Thus, no output voltage is then supplied by power source 100. Microcontroller module 130 may control DC/DC converter module 150 to be enabled after expiry of the period of time to check whether the short-circuit still exists.

It has to be understood that determining the load type may be performed by the microcontroller module 130 by means of hardware, software or a mix of both.

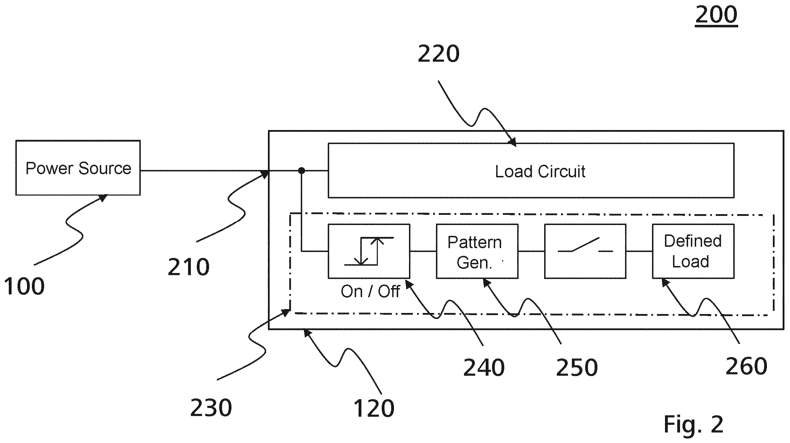

Fig. 2 shows a block diagram 200 that describes load 120 in more detail. Load 120 comprises an input 210 and an electronic circuit 230. The electronic circuit 230 is configured to determine a voltage at the input 210 and to set a current consumption of the load 120 based on the determined voltage. The current consumption of the load is set according to a current pattern that is associated with a type of the load.

The input 210 of load 120 may be connected to a power source 100 via a power transmission line. The load 120 comprises a load circuit 220 corresponding to the function of load 120. Electronic circuit 230 may be a load type identification module 230 that provides identification of the load type to power source 100.

In one embodiment the load type identification module 230 comprises a voltage range detection module 240 configured to determine the voltage at the input 210. Voltage range detection module 240 has an input coupled to the input 210 of load 120. When the voltage range detection module 240 determines that the input voltage of the load 120 is in a predefined range, voltage range detection module 240 enables module 250. In one embodiment, voltage range detection module 240 enables module 250 when the power source 100 provides the first voltage but disables module 250 when the power source 100 provides the second voltage.

In one embodiment, module 250 may be a pattern generator that switches a load module 260 on and off. When the load module 260 is switched on, a first current is set. When the load module 260 is switched off, a second current is set that is lower than the first current. Thereby, the current consumption of the load 120 changes according to a pattern provided by the pattern generator. The pattern may be a frequency or a duty cycle. In another embodiment, module 250 may be a bit pattern generator that provides a predefined digital signal for switching the load module 260 on and off. Thereby, the current consumption of the load 120 changes according to a pattern provided by the bit pattern generator. The pattern identifies the type of load. There may be multiple pattern for multiple types of load, whereby one pattern is associated with one type of load. In an embodiment, the load module 260 comprises a resistor. In an embodiment, circuit 250 comprises a microcontroller.

In one embodiment of the present invention, the load 120 may comprise power source 100. This allows to daisy-chain multiple loads 120 that are enabled one after another according to the function of power source 100 as described above.

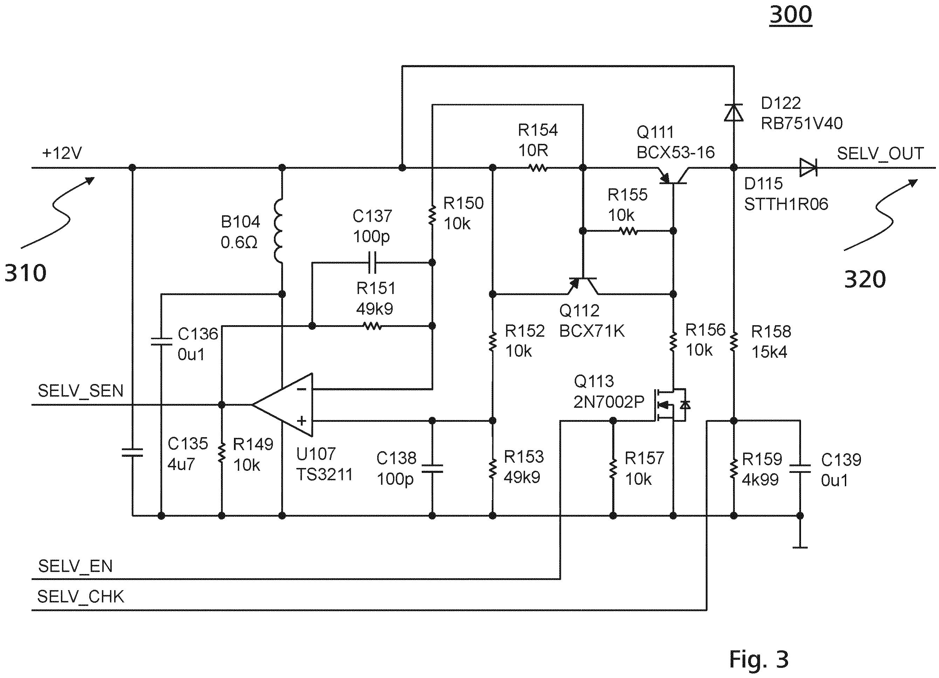

Fig. 3 shows circuit 300, which is an embodiment of over-current protection module 170, a voltage/current measurement module 180 and a reverse power protection module 190.

The circuit 300 receives a +12 DC input voltage at the input 310. Over-current protection module 170 is embodied as transistors Q111, Q112, shunt resistor R154 and resistor R155. In one embodiment, Q111 is a PNP transistor. The emitter of Q111 is coupled via resistor R154 to the input 310. The collector of Q111 is coupled to output 320. Resistor R155 provides Q111 a base-to-emitter voltage that leads Q111 to conduct. The voltage drop over shunt resistor R154 is proportional to the current flowing through shunt resistor R154. If the voltage drop increases, transistor Q112 starts to conduct and limits the base-to-emitter voltage of Q111 such that the current at the output 320 is reduced. Q111 may be forced to be close (i.e. Q111 is conducting) by applying a logical high at input SELV_EN. This causes transistor Q113 to conduct and to increase the base-to-emitter voltage of Q111 via resistor 156.

Voltage/ current measurement module 180 is embodied as resistors R150 to R153, R158, R159 capacitors 137 to 139 and operational amplifier U107. Resistors R158 and R159 provide a divided portion of the output voltage at the output SELV_CHK. Capacitor C139 together with resistors R158 and R159 functions as a low pass filter.

U107 amplifies the voltage drop over shunt resistor R154 and provides a signal SELV_SEN that is proportional to the current through shunt resistor R154.

Reverse power protection module 190 is embodied as diode D115.

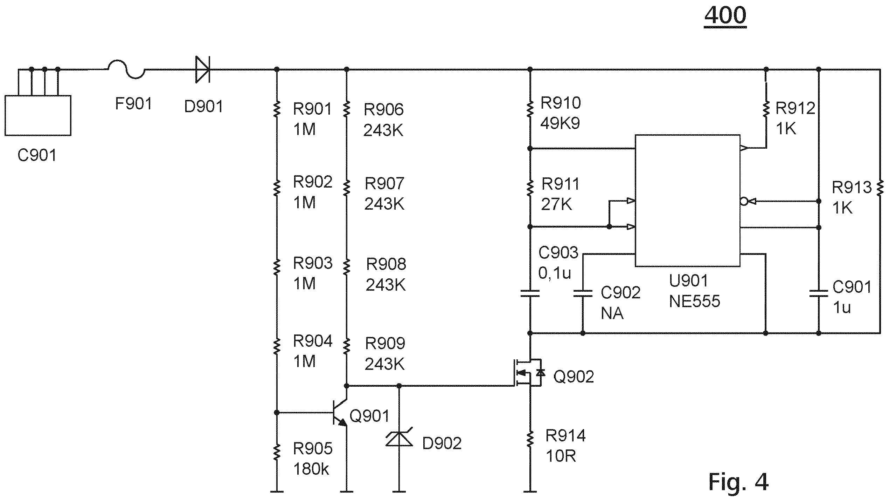

Fig. 4 shows an embodiment 400 of load type identification module 230 of load 120. Load type identification module 230 provides voltage range detection module 240 embodied as R901 to R909, transistors Q901, Q902 and Zener diode D902. The lower voltage of voltage range detection module 240 is embodied as resistors R906 to R909, diode 902 and the threshold voltage of Q902. If the input voltage is high enough that voltage drop over Zener diode 902 is above the gate-source threshold voltage of Q902, Q902 enables module 250, embodied as a-stable multi-vibrator U901. The upper voltage of voltage range detection module 240 is defined by resistors R901 to R904 and R905 that form a voltage divider for supplying a base-to-emitter voltage to NPN transistor Q901. If the base-to-emitter voltage is in the range of 0.6 to 0.7 V, transistor Q901 starts to conduct and reduces the gate to source voltage of transistor Q902. This causes transistor Q902 to disable module 250, i.e. a-stable multi-vibrator U901.

In the embodiment of Fig. 4, the pattern that identifies the type of load is the frequency and duty-cycle of the signal generated by pattern generator U901. The frequency and duty cycle is defined by R910, R911 and C903. The load module 260 is embodied by resistor R912.

While the invention has been illustrated and described in detail in the drawings and the foregoing description, such illustration and description are to be considered illustrative or exemplary and not restrictive. The invention is not limited to the disclosed embodiments. From reading the present disclosure, other modifications will be apparent to a person skilled in the art. Such modifications may involve other features, which are already known in the art and may be used instead of or in addition to features already described herein.

The invention has been described in conjunction with various embodiments herein. However, other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims.

A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. A power source (100), comprising:
an output (110) for a load (120);
the power source (100) being configured to:
provide, in a first operating state of the power source (100), a first voltage at the output (110) for the load (120);
detect a feedback from the load (120) at the output (110); and
provide, in a second operating state of the power source (100), a second voltage higher than the first voltage at the output (110) for the load (120) based on the detected feedback, wherein the detected feedback is a measured current when the first voltage is provided for the load (120), and
wherein the power source is further configured to detect the feedback by:
determining a pattern of the measured current that is associated with a type of the load (120),
wherein the pattern is defined by a digital bit pattern,
wherein the power source (100) further comprises:
an input (140) configured to receive an input voltage;
a voltage converter module (150) configured to generate the first voltage based on the input voltage,
a switch module (160) comprising a switch connected between the input (140) and the output (110),
wherein the power source (100) is configured to:
operate the switch in a first position for providing the first voltage at the output (110), and
operate the switch in a second position for providing the second voltage at the output (110),
wherein the voltage converter module (150) comprises an output,
**characterized in that** the output of the voltage converter module (150) is coupled to the output (110) of the power source (100) via a reverse power protection module (190),
wherein the power source (100) is configured to deactivate the voltage converter module (150) when the second voltage is provided.

2. The power source (100) of claim 1, further comprising an over-current protection module (170) configured to provide the first voltage with a current limit.

3. The power source (100) of claim 1 or 2, wherein the first voltage is a voltage below 60 VDC and the second voltage is a hazardous voltage.

4. The power source (100) of claim 3, wherein the first voltage is secure extra low voltage, SELV.

5. A method for providing power by a power source (100) for a load (120), comprising:
providing, in a first operating state of the power source (100), a first voltage at an output (110) of the power source (100) for the load (120);
detecting a feedback from the load (120) at the output (110);
providing, in a second operating state of the power source (100), a second voltage higher than the first voltage at the output (110) for the load (120) based on the detected feedback,
wherein the detected feedback is a measured current when the first voltage is provided for the load (120), and
wherein the detecting a feedback at the output (110) comprises:
determining a pattern of the measured current that is associated with a type of the load (120),
wherein the pattern is defined by a digital bit pattern,
wherein the power source (100) further comprises:
an input (140) configured to receive an input voltage;
a voltage converter module (150) configured to generate the first voltage based on the input voltage,
a switch module (160) comprising a switch connected between the input (140) and the output (110),
wherein the power source (100) is configured to:
operate the switch in a first position for providing the first voltage at the output (110), and
operate the switch in a second position for providing the second voltage at the output (110),
wherein the voltage converter module (150) comprises an output,
**characterized in that** the output of the voltage converter module (150) is coupled to the output (110) of the power source (100) via a reverse power protection module (190),
wherein the power source (100) deactivates the voltage converter module (150) when the second voltage is provided.

## Patentansprüche

1. Stromquelle (100), umfassend:
einen Ausgang (110) für eine Last (120);
wobei die Stromquelle (100) zu Folgendem konfiguriert ist:
Bereitstellen einer ersten Spannung an dem Ausgang (110) für die Last (120) in einem ersten Betriebszustand der Stromquelle (100);
Erfassen einer Rückkopplung von der Last (120) an dem Ausgang (110); und
Bereitstellen einer zweiten Spannung, die höher ist als die erste Spannung, an dem Ausgang (110) für die Last (120) in einem zweiten Betriebszustand der Stromquelle (100) basierend auf der erfassten Rückkopplung, wobei die erfasste Rückkopplung ein gemessener Strom ist, wenn die erste Spannung für die Last (120) bereitgestellt wird, und
wobei die Stromquelle ferner dazu konfiguriert ist, die Rückkopplung durch Folgendes zu erfassen:
Bestimmen eines Musters des gemessenen Stroms, das einem Typ der Last (120) zugeordnet ist,
wobei das Muster durch ein digitales Bitmuster definiert ist, wobei die Stromquelle (100) ferner Folgendes umfasst:
einen Eingang (140), der dazu konfiguriert ist, eine Eingangsspannung zu empfangen;
ein Spannungswandlermodul (150), das dazu konfiguriert ist, die erste Spannung basierend auf der Eingangsspannung zu erzeugen, ein Schaltmodul (160), das einen zwischen dem Eingang (140) und dem Ausgang (110) angeschlossenen Schalter umfasst,
wobei die Stromquelle (100) zu Folgendem konfiguriert ist:
Betreiben des Schalters in einer ersten Position zum Bereitstellen der ersten Spannung an dem Ausgang (110), und
Betreiben des Schalters in einer zweiten Position zum Bereitstellen der zweiten Spannung an dem Ausgang (110),
wobei das Spannungswandlermodul (150) einen Ausgang umfasst,
**dadurch gekennzeichnet, dass** der Ausgang des Spannungswandlermoduls (150) über ein Rückstromschutzmodul (190) mit dem Ausgang (110) der Stromquelle (100) gekoppelt ist, wobei die Stromquelle (100) dazu konfiguriert ist, das Spannungswandlermodul (150) zu deaktivieren, wenn die zweite Spannung bereitgestellt wird.

2. Stromquelle (100) nach Anspruch 1, ferner umfassend ein Überstromschutzmodul (170), das dazu konfiguriert ist, die erste Spannung mit einer Strombegrenzung bereitzustellen.

3. Stromquelle (100) nach Anspruch 1 oder 2, wobei die erste Spannung eine Spannung unter 60 VDC ist und die zweite Spannung eine gefährliche Spannung ist.

4. Stromquelle (100) nach Anspruch 3, wobei die erste Spannung eine sichere Kleinspannung (SELV) ist.

5. Verfahren für Bereitstellung von Leistung durch eine Stromquelle (100) für eine Last (120), umfassend:
Bereitstellen einer ersten Spannung an einem Ausgang (110) der Stromquelle (100) für die Last (120) in einem ersten Betriebszustand der Stromquelle (100);
Erfassen einer Rückkopplung von der Last (120) an dem Ausgang (110);
Bereitstellen einer zweiten Spannung, die höher ist als die erste Spannung, an dem Ausgang (110) für die Last (120) in einem zweiten Betriebszustand der Stromquelle (100) basierend auf der erfassten Rückkopplung,
wobei die erfasste Rückkopplung ein gemessener Strom ist, wenn die erste Spannung für die Last (120) bereitgestellt wird, und
wobei das Erfassen einer Rückkopplung an dem Ausgang (110) Folgendes umfasst:
Bestimmen eines Musters des gemessenen Stroms, das einem Typ der Last (120) zugeordnet ist,
wobei das Muster durch ein digitales Bitmuster definiert ist,
wobei die Stromquelle (100) ferner Folgendes umfasst:
einen Eingang (140), der dazu konfiguriert ist, eine Eingangsspannung zu empfangen;
ein Spannungswandlermodul (150), das dazu konfiguriert ist, die erste Spannung basierend auf der Eingangsspannung zu erzeugen,
ein Schaltmodul (160), das einen zwischen dem Eingang (140) und dem Ausgang (110) angeschlossenen Schalter umfasst,
wobei die Stromquelle (100) zu Folgendem konfiguriert ist:
Betreiben des Schalters in einer ersten Position zum Bereitstellen der ersten Spannung an dem Ausgang (110), und
Betreiben des Schalters in einer zweiten Position zum Bereitstellen der zweiten Spannung an dem Ausgang (110),
wobei das Spannungswandlermodul (150) einen Ausgang umfasst,
**dadurch gekennzeichnet, dass** der Ausgang des Spannungswandlermoduls (150) über ein Rückstromschutzmodul (190) mit dem Ausgang (110) der Stromquelle (100) gekoppelt ist, wobei die Stromquelle (100) das Spannungswandlermodul (150) deaktiviert, wenn die zweite Spannung bereitgestellt wird.

## Revendications

1. Source d'alimentation (100), comprenant :
une sortie (110) pour une charge (120) ;
la source d'alimentation (100) étant configurée pour :
fournir, dans un premier état de fonctionnement de la source d'alimentation (100), une première tension au niveau de la sortie (110) pour la charge (120) ;
détecter une rétroaction de la charge (120) au niveau de la sortie (110) ; et
fournir, dans un second état de fonctionnement de la source d'alimentation (100), une seconde tension supérieure à la première tension au niveau de la sortie (110) pour la charge (120) sur la base de la rétroaction détectée, dans laquelle la rétroaction détectée est un courant mesuré lorsque la première tension est fournie pour la charge (120), et
dans laquelle la source d'alimentation est également configurée pour détecter la rétroaction par :
la détermination d'un motif du courant mesuré qui est associé à un type de la charge (120),
dans laquelle le motif est défini par un motif de bits numériques,
dans laquelle la source d'alimentation (100) comprend également :
une entrée (140) configurée pour recevoir une tension d'entrée ;
un module convertisseur de tension (150) configuré pour générer la première tension sur la base de la tension d'entrée,
un module de commutation (160) comprenant un commutateur connecté entre l'entrée (140) et la sortie (110),
dans laquelle la source d'alimentation (100) est configurée pour :
actionner le commutateur dans une première position pour fournir la première tension au niveau de la sortie (110), et
actionner le commutateur dans une seconde position pour fournir la seconde tension au niveau de la sortie (110),
dans laquelle le module convertisseur de tension (150) comprend une sortie,
**caractérisée en ce que** la sortie du module convertisseur de tension (150) est couplée à la sortie (110) de la source d'alimentation (100) via un module de protection contre les inversions de puissance (190),
dans laquelle la source d'alimentation (100) est configurée pour désactiver le module convertisseur de tension (150) lorsque la seconde tension est fournie.

2. Source d'alimentation (100) selon la revendication 1, comprenant également un module de protection contre les surintensités (170) configuré pour fournir la première tension avec une limite de courant.

3. Source d'alimentation (100) selon la revendication 1 ou 2, dans laquelle la première tension est une tension inférieure à 60 VCC et la seconde tension est une tension dangereuse.

4. Source d'alimentation (100) selon la revendication 3, dans laquelle la première tension est une très basse tension sécurisée, SELV.

5. Procédé de fourniture d'énergie par une source d'alimentation (100) pour une charge (120), comprenant :
la fourniture, dans un premier état de fonctionnement de la source d'alimentation (100), d'une première tension au niveau d'une sortie (110) de la source d'alimentation (100) pour la charge (120) ;
la détection d'une rétroaction de la charge (120) au niveau de la sortie (110) ;
la fourniture, dans un second état de fonctionnement de la source d'alimentation (100), d'une seconde tension supérieure à la première tension au niveau de la sortie (110) pour la charge (120) sur la base de la rétroaction détectée,
dans lequel la rétroaction détectée est un courant mesuré lorsque la première tension est fournie pour la charge (120), et
dans lequel la détection d'une rétroaction au niveau de la sortie (110) comprend :
la détermination d'un motif du courant mesuré qui est associé à un type de la charge (120),
dans lequel le motif est défini par un motif de bits numériques,
dans lequel la source d'alimentation (100) comprend également :
une entrée (140) configurée pour recevoir une tension d'entrée ;
un module convertisseur de tension (150) configuré pour générer la première tension sur la base de la tension d'entrée,
un module de commutation (160) comprenant un commutateur connecté entre l'entrée (140) et la sortie (110),
dans lequel la source d'alimentation (100) est configurée pour :
actionner le commutateur dans une première position pour fournir la première tension au niveau de la sortie (110), et
actionner le commutateur dans une seconde position pour fournir la seconde tension au niveau de la sortie (110),
dans lequel le module convertisseur de tension (150) comprend une sortie,
**caractérisé en ce que** la sortie du module convertisseur de tension (150) est couplée à la sortie (110) de la source d'alimentation (100) via un module de protection contre les inversions de puissance (190),
dans lequel la source d'alimentation (100) désactive le module convertisseur de tension (150) lorsque la seconde tension est fournie.
